# EUROPEAN PATENT SPECIFICATION

(11) **EP 0 526 147 B1**
(45) Date of publication and mention of the grant of the patent: **20.10.1999**
(21) Application number: 92306840.7
(22) Date of filing: 27.07.1992
(51) Int. Cl.: H01L 23/498, H01L 21/60

(54) **Film-carrier type semiconductor device and process for fabricating the same**
Halbleiteranordnung vom Filmträgertyp und Verfahren zum Herstellen derselben
Dispositif semi-conducteur du type à bande de support et procédé de sa fabrication

(30) Priority: 25.07.1991 JP 18595691
(43) Date of publication of application: 03.02.1993
(73) Proprietor: NEC CORPORATION, Tokyo (JP)
(72) Inventor: Ichii, Toyokazu, c/o NEC Corporation, Tokyo (JP); Takuma, Yoichirou, c/o NEC Corporation, Tokyo (JP)
(74) Representative: Moir, Michael Christopher

(56) References cited:
- EP-A- 0 178 227
- EP-A- 0 260 490
- EP-A- 0 427 384
- FR-A- 1 534 329
- PATENT ABSTRACTS OF JAPAN vol. 14, no. 441 (E-981)20 September 1990 & JP-A-2 172245 ( HITACHI LTD )

## Description

### BACKGROUND OF THE INVENTION

### Field of the Invention

This invention relates to a film carrier type semiconductor device and a process for manufacturing the same. It relates more particularly to such type of semiconductor device with multiterminals and a process for manufacturing the same.

### Description of the Prior Art

Such film carrier type semiconductor devices, for example, as described in U.S. Patent No. 3,689,991, comprises a carrier tape of insulating film provided with device holes centrally located at regularly spaced intervals, a row of sprocket perforations at regularly spaced intervals at each edge, and copper foil leads formed in a predetermined pattern around each device hole on the surface, and semiconductor chips each mounted within a device hole and provided with a plurality bonding pads connected to the copper foil leads by the gang bonding under thermocompression or eutectic occurrence to the copper foil leads. After this electrode leads interconnection, the semiconductor chips located within the device holes are molded with a resinous material into a plate. The product is checked as itself for electrical characteristics before shipment.

As described above, the film carrier type semiconductor device permits to use gang bonding for connection between the electrode bonding pads on a chip and the copper foil leads and hence its productivity is high. The shipment in the form of being carried on such carrier tape is convenient also for being applied to automated process of assembling electronic devices. Thanks to this construction, the film carrier type semiconductor device permits thin package, and hence suitable for miniaturization of electronic devices. The semiconductor device carrier is flexible and therefore suitable for use in a circuit in which other circuit elements are required to be arranged in three-dimensions, such as the driver circuit of an LCD display.

The film carrier type semiconductor device has many advantages as mentioned above but presents difficult problem associated with the process of gang bonding between the electrode bonding pads and the copper foil leads. For ensuring this, it is needed to place metal pieces between them.

One method of solving this problem is to deposit a suitable metallic ball to each bonding pad on a semi-conductor chip, as described in U.S.P. specification No. 3,380,155 (Japanese Patent Laid-open Application No. Sho.54-2662). The metallic ball deposition must previously be carried out to many bonding pads, and therefore this method is not only low in productivity but also difficult to ensure uniform height of metallic balls required for the gang bonding process.

Another method of solving the problem is to process each copper foil lead for the open end thereof to be thick. An example was proposed in the Solid State Technology, in Japanese, pp. 33-35, Nov. 1978, in which, for leaving the open end portion of each copper foil lead to be thicker as a bump, the remaining portion was half-etched to be thinner. This however requires complicated patterning for the half-etching of the portions of copper foil leads, and difficult to be applied to the processing of copper foils on the carrier tape when the latter is made from insulating material.

A further proposition was described in Japanese Published Patent No. Sho.61-31819 in which metal pieces to be bumps are performed by electroplating at the corresponding positions on a substrate as of glass to the open end portions of the copper foil leads, and transferred to, and deposited as bumps onto, the surfaces of the copper leads on a carrier tape. This method is considered as effective in cost reduction with extra need of electroplating for formation of metal pieces as bumps, and has not achieved simplification from viewpoint of the entire process.

EP-A-0 427 384 describes a method of connecting a TAB tape to a semiconductor chip which comprises locating and fixing bumps in an auxiliary tape section in an array corresponding to a pattern of electrodes of the semiconductor chip, and bonding the bumps by thermocompression to the electrodes of the semiconductor chip and the leads of the TAB tape so that each electrode of the semiconductor chip is electrically connected to the corresponding lead of the TAB tape through a corresponding bump.

EP-A-0 260 490 describes a method of bonding an electrical component in which a carrier tape section comprising a low melting point bonding metal is interposed between a conductor pattern of a substrate and electrode terminals of an electronic component and is bonded by thermocompression. The low melting point bonding metal comprises a plurality of elongate wiring conductors each having a first portion formed in the carrier tape section and a second portion extending into a central opening formed in the carrier tape section.

EP-A-0 324 244 describes integration of passive elements into a film carrier type semiconductor device, in which a tape automated bonding package for a semiconductor chip comprises a pattern of electrical leads formed on an electrically insulating polymer layer for interconnecting a semiconductor chip to a printed circuit substrate.

FR-A-1,534,329 describes a film carrier type semiconductor device wherein the semiconductor chip is enclosed with a device hole by a sealing material.

It therefore is an object of the present invention to provide a film carrier type semiconductor device in which it is unnecessary to form bumps on the electrode bonding pads on the semiconductor chip and on the copper foil leads on the carrier tape, which contributes to improved productivity.

Another object of the present invention is to provide a process of manufacturing the film carrier type semiconductor devices mentioned in the preceding paragraph.

A further object of the present invention is to provide a film carrier type semiconductor device including a multiterminal semiconductor chip.

A further object of the present invention is to provide a process of manufacturing the film carrier type semiconductor device mentioned in the preceding paragraph.

In one aspect the invention provides a film carrier type semiconductor device comprising:
a semiconductor chip having a plurality of bonding pads formed at the periphery of a major surface thereof;
a first carrier tape section of insulating material having a device hole wider than said major surface of said semiconductor chip to locate said semiconductor chip therein;
a second carrier tape section of insulating material having first and second major surfaces each having a surface area smaller than that of said major surface of said semiconductor chip, said first major surface being fixed to a central portion of said major surface of said semiconductor chip leaving said bonding pads exposed;
a plurality of elongate wiring conductors each having a first portion formed on said second major surface of said second carrier tape section and a second portion extending beyond the outer periphery of said second carrier tape section and being in direct contact with and thus directly bonded to an associated one of said bonding pads of said semiconductor chip; and
a plurality of metal leads each formed on a surface of said first carrier tape section, projecting into said device hole, and in direct contact with and thus directly bonded to said second portion of an associated one of said plurality of elongate wiring conductors.

In another aspect the invention provides a process of manufacturing a film carrier type semiconductor device comprising the steps of:
preparing a semiconductor chip having a plurality of bonding pads formed at the periphery of a major surface thereof;
preparing a first carrier tape section of insulating material, said first carrier tape having a device hole wider than said major surface of said semiconductor chip to locate said semiconductor chip therein;
forming a plurality of metal leads on a surface of said first carrier tape section, said metal leads projecting into said device hole;
preparing a second carrier tape section of insulating material having first and second major surfaces each having a surface area smaller than that of said major surface of said semiconductor chip;
fixing the first major surface to a central portion of the major surface of the chip;
preparing a plurality of elongate wiring conductors each having a first portion formed on said second major surface of said second carrier tape section and a second portion extending beyond the outer periphery of said second carrier tape section; and
directly contacting and thus directly bonding each of said bonding pads of said semiconductor chip to said second portion of an associated one of said plurality of elongate wiring conductors and said second portion of each of the plurality of elongate wiring conductors to an associated one of said plurality of metal leads by thermocompression gang bonding.

Thus, for manufacturing the film carrier tape semiconductor device according to preferred forms of the present invention, in addition to the above-mentioned regular carrier tape provided with device holes, sprocket perforations, and copper foil leads, an auxiliary carrier tape is used which carries metal pieces formed at the surface edges by selective etching at the corresponding locations to the open ends of the copper foil leads and accordingly to be adhered to the bonding pads on the above-mentioned semiconductor chips. The regular carrier tape and the auxiliary tape are brought into the correct relative positions (ie. in registry with each other) with the latter directly under the former by aligning means and moved to thermocompression/eutectic occurrence means by means of a common sprocket, and there one end of each metal piece and the open end of each copper foil lead are bonded together. The resultant is moved mechanically to alignment between the open ends of the copper foil leads and the bonding pads of the semiconductor chip, and then gang bonding is performed therebetween.

The auxiliary tape can be sectioned into pieces each corresponding to one semiconductor chip before movement of it to the thermocompression/eutectic occurrence means. In this case, the alignment between the metal pieces and the edge copper foil leads is needed to be carried out before the processing by thermocompression/eutectic occurrence means. Also it is possible to perform the integration of both regular and auxiliary carrier tapes in the later stage, e.t. to perform, first, gang bonding of the metal pieces of the auxiliary carrier tape of the bonding pads on the semiconductor chip, and subsequently gang bonding between the resultant and the bumpless open ends of the copper foil leads on the regular carrier tape. In any of the above cases, the end of each metal piece of the auxiliary carrier tape is placed between each bonding pad on the semiconductor chip, and each copper foil lead of the regular carrier tape, and the three are bonded together with the main of the auxiliary carrier tape covering almost the surface of the semiconductor chip. This enables to mount circuit elements including capacitor and resistor on the surface of the auxiliary carrier tape through the use of the other end of each metal piece as connection terminal.

As apparent from the above-described construction and process, the film carrier type semiconductor device and the process for manufacture thereof reflects not only a simplified processing steps of manufacturing semiconductor devices of this type and in turn a raised productivity but also facility of mounting capacitor, resistor, or the like, on the surface of the auxiliary carrier tape serving as insulating film.

### BRIEF DESCRIPTION OF THE DRAWINGS

The above-mentioned and other objects, features and advantages of this invention will become more apparent by reference to the following detailed description of the invention taken in conjunction with the.accompanying drawings, wherein:
Fig. 1A is a plan view of a film carrier type semiconductor device in the prior art;
Fig. 1B is a cross-sectional view taken along line A-A of Fig. 1A;
Fig. 2A is a plan view of a film carrier type semiconductor device according to the present invention;
Fig. 2B is a cross-sectional view taken along line A-A of Fig. 2A;
Fig. 3A is a plan view of a part of a second carrier tape section which is a constructive component of the semiconductor device according to Figs. 2A and 2B;
Fig. 3B is a cross-sectional view taken along line A-A of Fig. 3A;
Fig. 4A through 4C are cross-sectional views illustrating a process of manufacturing the film carrier type semiconductor device according to Figs. 2A and 2B; and
Fig. 5A through 5C are cross-sectional views illustrating an alternative process of manufacturing the film carrier type semiconductor device according to Figs. 2A and 2B.

### DETAILED DESCRIPTION OF THE PREFERRED EMBODIMENTS

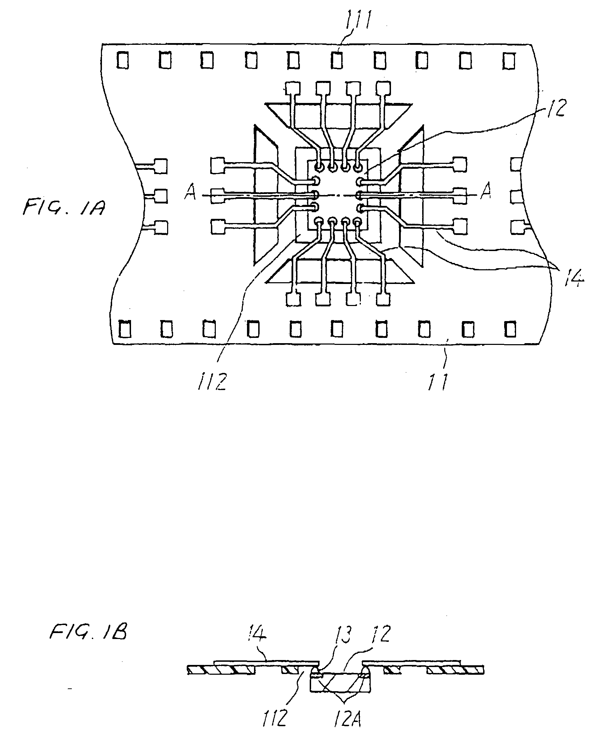

Referring to Figs. 1A and 1B, a film carrier type semiconductor device in the prior art shown in it consists of a first carrier tape 11 which is a longitudinally extending film made from insulating material such as polyimide and provided with centrally located longitudinally spaced device holes 112, a row of sprocket perforations 111 along each edge, and copper foil leads 14 printed on the surface by the printing wiring technique, and semiconductor devices each being contained within a device hole of the film carrier and having a metal bump 13 formed on each bonding pad 12.

As better understood from Fig. 1B, in the process of manufacturing the semiconductor device, gang bonding is performed between the copper foil leads 14 and the bonding pads 12A of a semiconductor device 12 through intermediation of bumps 13 under thermocompression or eutectic occurrence. Then each resulting semiconductor chip 12 is enclosed within a device hole 112 with resinous material. After being checked for electrical characteristics, and reeled, the product can be shipped out.

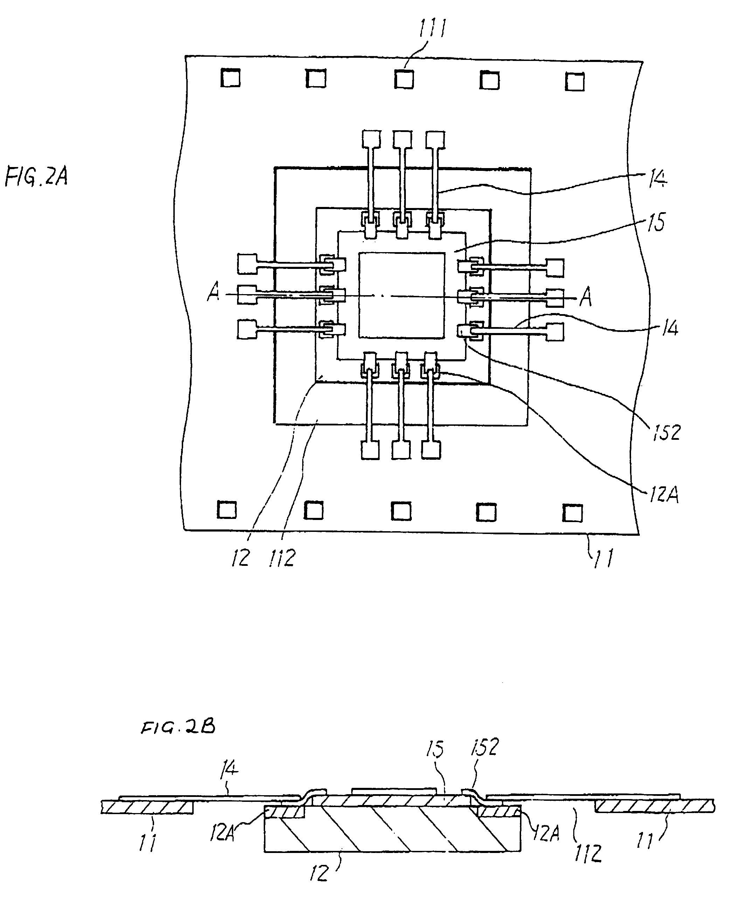

The embodiment of the present invention will be described below with reference to Figs. 2A and 2B in which the corresponding parts or components to those in Fig. 1 are designated with identical reference characters to those in Fig. 1. In this embodiment there is further provided a second or auxiliary carrier tape 15 with at each edge thereof elongate wiring conductors or metal pieces 152, each to be placed between the open end of a copper foil lead 14 on carrier tape 11 and a surface pad 121 of semiconductor chip 12. In Figs. 2A and 2B, shown only is the section or part of auxiliary carrier tape enclosed together with semiconductor chip using resinous material, excluding all the remaining part to be cut away.

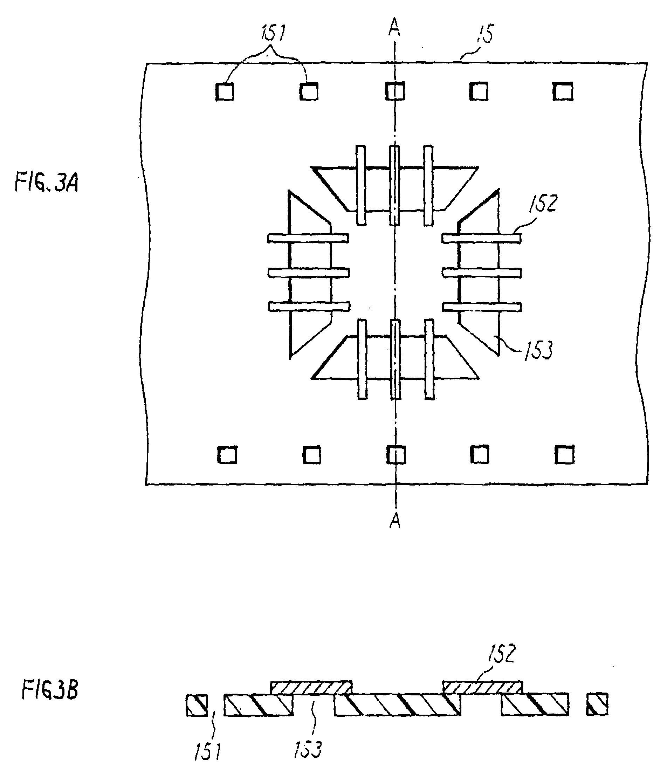

Referring to Figs. 3A and 3B, the auxiliary carrier tape 15 is a long film made from insulating material such as polyimide like the aforesaid carrier tape 11, and provided with a plurality of elongate wiring conductors or metal pieces 152 printed by the printed wiring technique at corresponding locations to the open ends of copper foil leads 14 on the surface of carrier tape 11, and extending across four trapezoid apertures 153. It is additionally provided with rows of sprocket perforations 151 corresponding to sprocket perforations 111 in carrier tape 11.

In the manufacturing process, auxiliary carrier tape 15 is laid directly under carrier tape 11, and moved by a sprocket driver (not shown) until metal pieces 152 are placed between, and aligned with, pads 12A of semiconductor chip 12 and the open ends of copper foil leads 14, and then subjected to gang bonding.

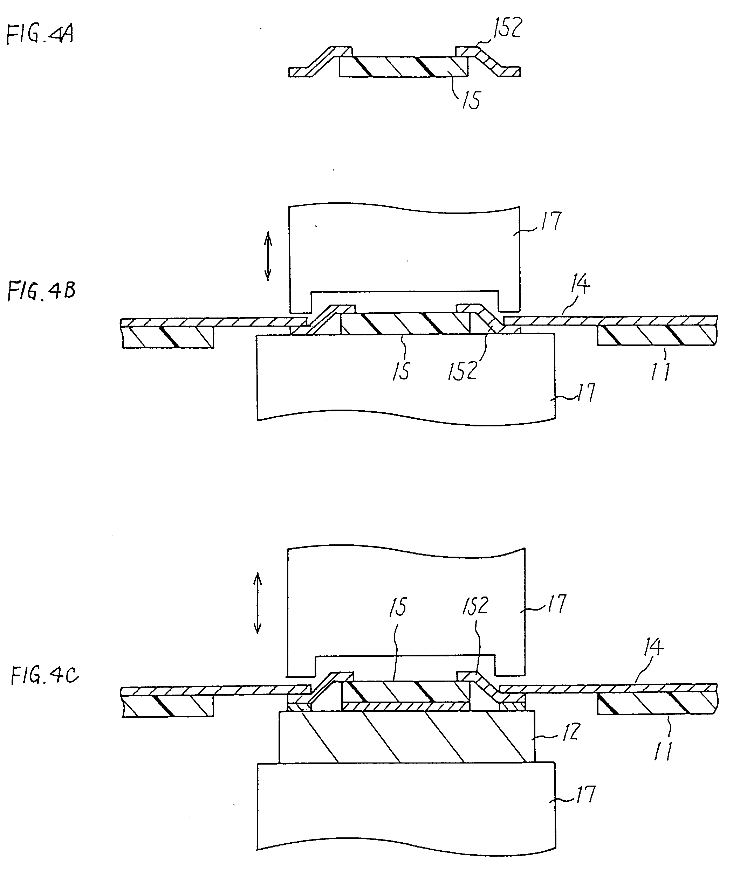

For ensuring the electrode lead interconnection in the gang bonding process, as illustrated in Figs. 4A, 4B and 4C, an auxiliary carrier tape 15 is laid directly under a carrier tape 11 with alignment between metal pieces 152 and the open ends of copper foil leads 14 on carrier tape 11, and then bonded by thermocompression means 17 (Fig. 4B). In the next stage, bonding between metal pieces 152 and pads 12A is made. Moreover it is possible that before bonding between auxiliary tape 15 and carrier tape 11, metal pieces 152 are severed within the trapezoid apertures 153 to form an auxiliary carrier piece, as shown in Fig. 4A, and each auxiliary carrier piece is used for bonding to copper foil leads 14. In this case it is preferred to, after the severing, apply force in the thickness direction of the auxiliary carrier tape 15 to have the metal pieces 152 curved or cranked. Figs. 4A, 4B and 4C show the processing steps using the curved metal pieces.

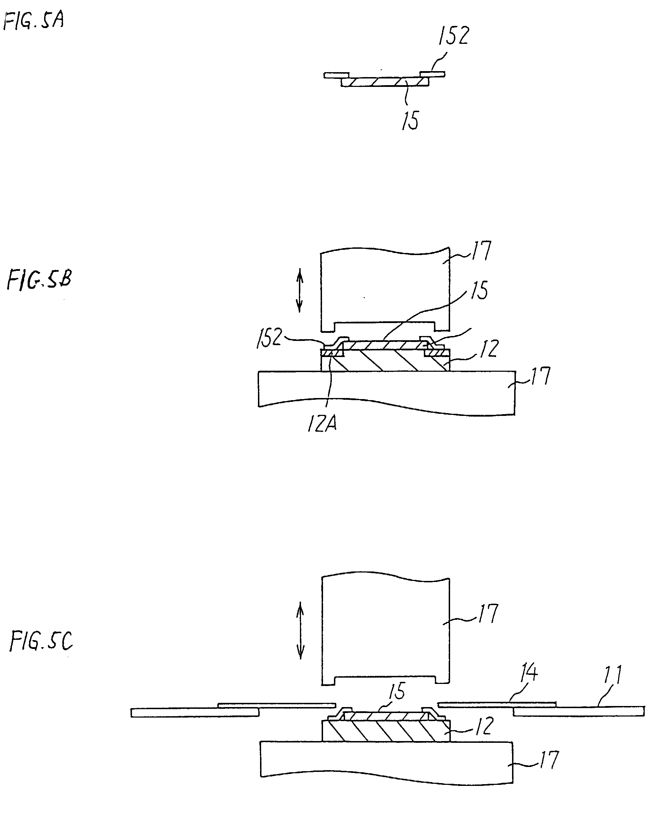

It also is possible to firstly bond metal pieces 152 of an auxiliary carrier tape 15 to pads 12A of semiconductor chips 12, and then lay a regular carrier tape 11 on top of the resultant and bond the under surface of the open ends of copper foil leads 14 to metal pieces 152 already bonded to pads 12A of the semiconductor chips 12 (See Figs. 5A, 5B and 5C).

Besides the desired length of metal pieces 152 is suitably determined, taking the thickness of auxiliary carrier tape 15 and the dimension of electrode pads 12A into consideration. For example, assuming the thickness of auxiliary carrier tape 15 to be 125 µm and the dimension of electrode pads 12A to be 100 µm, then the length of metal pieces 152 may be set to any between 200 and 300 µm. The smaller the thickness of auxiliary carrier tape 15 is, the shorter the metal piece 152 is permitted to be, and the easier it becomes to cope with the tendency towards more multiterminals.

In the above-described embodiment, when much heat is generated for semiconductor chip 12 and hence a heat sink is necessary, the latter is mounted within the area encompassed by metal pieces 152 of auxiliary carrier tape 15 through a thin metal plate for reinforcement.

As an additional advantage, for example when the semiconductor chip 12 operates at high frequency and hence associated passive circuit elements such as capacitors and resistor must be closely adjacent, these passive elements can be arranged on the surface of auxiliary carrier tape 15 with their terminals connected to the other ends of metal pieces 152.

Although the invention has been described with reference to specific embodiments, this description is not meant to be construed in a limiting sense. Various modifications of the disclosed embodiments, as well as other embodiments of the invention, will become apparent to persons skilled in the art upon reference to the description of the invention. It is therefore contemplated that the appended claims will cover any modifications or embodiments as fall within true scope of the invention.

## Claims

1. A film carrier type semiconductor device comprising:
a semiconductor chip (12) having a plurality of bonding pads (12A) formed at the periphery of a major surface thereof;
a first carrier tape section (11) of insulating material having a device hole (112) wider than said major surface of said semiconductor chip (12) to locate said semiconductor chip (12) therein;
a second carrier tape section (15) of insulating material having first and second major surfaces each having a surface area smaller than that of said major surface of said semiconductor chip (12), said first major surface being fixed to a central portion of said major surface of said semiconductor chip (12) leaving said bonding pads (12A) exposed;
a plurality of elongate wiring conductors (152) each having a first portion formed on said second major surface of said second carrier tape section (15) and a second portion extending beyond the outer periphery of said second carrier tape section (15) and being in direct contact with and thus directly bonded to an associated one of said bonding pads (12A) of said semiconductor chip (12); and
a plurality of metal leads (14) each formed on a surface of said first carrier tape section (11), projecting into said device hole (112), and in direct contact with and thus directly bonded to said second portion of an associated one of said plurality of elongate wiring conductors (152).

2. A film carrier type semiconductor device according to Claim 1, wherein a passive element is connected to a said elongate wiring conductor (152).

3. A film carrier type semiconductor device according to Claim 1 or Claim 2 wherein the semiconductor chip (12) is enclosed within the device hole (112) by sealing material.

4. A process of manufacturing a film carrier type semiconductor device comprising the steps of:
preparing a semiconductor chip (12) having a plurality of bonding pads (12A) formed at the periphery of a major surface thereof;
preparing a first carrier tape section (11) of insulating material, said first carrier tape having a device hole (112) wider than said major surface of said semiconductor chip (12) to locate said semiconductor chip (12) therein;
forming a plurality of metal leads (14) on a surface of said first carrier tape section (11), said metal leads projecting into said device hole (112);
preparing a second carrier tape section (15) of insulating material having first and second major surfaces each having a surface area smaller than that of said major surface of said semiconductor chip (12);
fixing the first major surface to a central portion of the major surface of the chip;
preparing a plurality of elongate wiring conductors (152) each having a first portion formed on said second major surface of said second carrier tape section (15) and a second portion extending beyond the outer periphery of said second carrier tape section (15); and
directly contacting and thus directly bonding each of said bonding pads (12A) of said semiconductor chip (12) to said second portion of an associated one of said plurality of elongate wiring conductors (152) and said second portion of each of the plurality of elongate wiring conductors to an associated one of said plurality of metal leads (14) by thermocompression gang bonding.

5. A process according to Claim 4 wherein the second carrier tape section (15) is aligned under the first carrier tape section (11) so that each elongate wiring conductor (152) is aligned with an associated metal lead (14) and bonding pad (12A), and the metal leads (14) are bonded to the elongate wiring conductors (152) before the elongate wiring conductors (152) are bonded to the bonding pads of the semiconductor chip (12).

6. A process according to Claim 4, wherein the elongate wiring conductors (152) are bonded to the bonding pads (12A) of the semiconductor chip (12) before the second tape section (15) is aligned with the first carrier tape section (11) so that the elongate wiring conductors (152) are aligned with the metal leads (14), and subsequently the elongate wiring conductors (152) are bonded to the metal leads (14).

7. A process according to Claim 5, comprising providing the first carrier tape section (11) and the second carrier tape section (15) as parts of respective carrier tapes comprising a plurality of successive said sections, wherein said first and second sections are aligned by engaging corresponding drive perforations (111, 151) in said first and second carrier tapes, said second portion of each elongate wiring conductor (152) being sectioned from the respective carrier tape prior to bonding to said associated metal lead (14).

## Patentansprüche

1. Halbleitereinrichtung vom Filmträgertyp, die aufweist:
einen Halbleiterchip (12) mit einer Vielzahl von Kontaktflecken (12A), die am Umfang einer größeren Oberfläche desselben angeordnet sind;
einen ersten Trägerfilmabschnitt (11) aus isolierendem Material, der ein Einrichtungsloch (112) aufweist, das größer ist als die größere Oberfläche des Halbleiterchips (12), um den Halbleiterchip (12) darin anzuordnen;
einen zweiten Trägerfilmabschnitt (15) aus isolierendem Material, der erste und zweite größere Oberflächen aufweist, die jeweils ein Oberflächengebiet haben, das kleiner ist als dasjenige der größeren Oberfläche des Halbleiterchips (12), wobei die erste größere Oberfläche an einem mittigen Bereich der größeren Oberfläche des Halbleiterchips (12) befestigt ist, wobei die Kontaktflecken (12A) freiliegend bleiben;
eine Vielzahl von länglichen Verdrahtungsleitern (152), von denen jeweils ein erster Bereich auf der zweiten größeren Oberfläche des zweiten Trägerfilmabschnitts (15) ausgebildet ist und sich ein zweiter Bereich über den äußeren Umfang des zweiten Trägerfilmabschnitts (15) erstreckt und in direkter Berührung mit einem zugeordneten der Kontaktflecken (12A) des Halbleiterchips (12) ist und mit demselben direkt gebondet ist; und
eine Vielzahl von Metalleitungen (14), die auf einer Oberfläche des ersten Trägerfilmabschnitts (11) ausgebildet sind, in das Einrichtungsloch (112) hineinragen und in direkter Berührung sind mit dem zweiten Bereich eines der zugeordneten der Mehrzahl von länglichen Verdrahtungsleitern (152) und so direkt mit demselben gebondet sind.

2. Halbleitereinrichtung vom Filmträgertyp nach Anspruch 1, bei dem ein passives Element mit dem länglichen Verdrahtungsleiter (152) verbunden ist.

3. Halbleitereinrichtung vom Filmträgertyp nach Anspruch 1 oder Anspruch 2, bei der der Halbleiterchip (12) innerhalb des Einrichtungsloches (112) durch Umhüllungsmaterial umschlossen ist.

4. Verfahren zum Herstellen einer Halbleitereinrichtung vom Filmträgertyp, das die Schritte aufweist:
einen Halbleiterchip (12) mit einer Vielzahl von Kontaktflecken (12A) herzustellen, die am Umfang einer größeren Oberfläche desselben ausgebildet sind;
einen ersten Trägerfilmabschnitt (11) aus isolierendem Material herzustellen, welcher erste Trägerfilm ein Einrichtungsloch (112) aufweist, das größer ist als die größere Oberfläche des Halbleiterchips (12), um den Halbleiterchip (12) darin anzuordnen;
eine Mehrzahl von Metalleitungen (14) auf einer Oberfläche des ersten Trägerfilmabschnitts (11) auszubilden, welche Metalleitungen in das Einrichtungsloch (112) ragen;
einen zweiten Trägerfilmabschnitt (15) aus isolierendem Material herzustellen, der erste und zweite größere Oberflächen aufweist, die jeweils ein Oberflächengebiet haben, das kleiner ist als dasjenige der größeren Oberfläche des Halbleiterchips (12);
die erste größere Oberfläche an einem mittigen Bereich der größeren Oberfläche des Chips zu befestigen;
eine Vielzahl von länglichen Verdrahtungsleitern (152) zu bilden, die jeweils einen ersten Bereich, der auf der zweiten größeren Oberfläche des zweiten Trägerfilmabschnittes (15) ausgebildet ist, und einen zweiten Bereich aufweisen, der sich über den äußeren Umfang des zweiten Trägerfilmabschnitts (15) erstreckt; und
direkt jeden der Kontaktflecken (12A) des Halbleiterchips (12) mit dem zweiten Bereich des zugeordneten der Mehrzahl von länglichen Verdrahtungsleitern (152) in Berührung zu bringen und auf diese Weise direkt zu bonden, und den zweiten Bereich jedes der Vielzahl von länglichen Verdrahtungsleitern mit einem zugeordneten der Mehrzahl von Metalleitungen (14) direkt in Berührung zu bringen und direkt damit durch Thermokompressionsgruppenbonden zu bonden.

5. Verfahren nach Anspruch 4, bei dem der zweite Trägerfilmabschnitt (15) unter dem ersten Trägerfilmabschnitt (11) ausgerichtet wird, so daß jeder längliche Verdrahtungsleiter (152) mit einer zugeordneten Metalleitung (14) und einem zugeordneten Kontaktflecken (12A) ausgerichtet ist, und die Metalleitungen (14) an die länglichen Verdrahtungsleiter (152) gebondet werden, bevor die länglichen Verdrahtungsleiter (152) an die Kontaktflecken des Halbleiterchips (12) gebondet werden.

6. Verfahren nach Anspruch 4, bei dem die länglichen Verdrahtungsleiter (152) an die Kontaktflecken (12A) des Halbleiterchips (12) gebondet werden, bevor der zweite Filmabschnitt (15) mit dem ersten Trägerfilmabschnitt (11) ausgerichtet wird, so daß die länglichen Verdrahtungsleiter (152) mit den Metalleitungen (14) ausgerichtet werden, und wobei die länglichen Verdrahtungsleiter (152) anschließend an die Metalleitungen (14) gebondet werden.

7. Verfahren nach Anspruch 5, welches aufweist, den ersten Trägerfilmabschnitt (11) und den zweiten Trägerfilmabschnitt (15) als Teil von entsprechenden Trägerfilmen vorzusehen, die eine Vielzahl von aufeinanderfolgenden solchen Abschnitten aufweisen, wobei die ersten und zweiten Abschnitte dadurch ausgerichtet werden, daß entsprechende Antriebsperforationen (111, 151) in den ersten und zweiten Trägerfilmen in Eingriff gebracht werden, wobei der zweite Abschnitt des länglichen Verdrahtungsleiters (152) vom entsprechenden Trägerfilm vor dem Bonden an die zugeordnete Metalleitung (14) getrennt wird.

## Revendications

1. Dispositif à semi-conducteurs du type à film de support comprenant :
une puce à semi-conducteurs (12) comportant une pluralité de plots de connexion (12A) formés à la périphérie d'une surface principale de celle-ci ;
une première section de bande de support (11) en un matériau isolant comportant un trou de dispositif (112) plus large que ladite surface principale de ladite puce à semi-conducteurs (12) pour y placer ladite puce à semi-conducteurs (12) ;
une seconde section de bande de support (15) en un matériau isolant ayant des première et seconde surfaces principales dont chacune a une aire de surface inférieure à celle de ladite surface principale de ladite puce à semi-conducteurs (12), ladite première surface principale étant fixée à une partie centrale de ladite surface principale de ladite puce à semi-conducteurs (12) en laissant exposés lesdits plots de connexions (12A) ;
une pluralité de conducteurs allongés de câblage (152) dont chacun comporte une première partie formée sur ladite seconde surface principale de ladite seconde section de bande de support (15) et une seconde partie s'étendant au-delà de la périphérie extérieure de ladite seconde section de bande de support (15) et qui est en contact direct avec, et ainsi directement liée à un plot associé desdits plots de connexions (12A) de ladite puce à semi-conducteurs (12) ; et
une pluralité de fils métalliques (14) dont chacun est formé sur une surface de ladite première section de bande de support (11), en pénétrant dans ledit trou de dispositif (112), et en contact direct avec, et ainsi directement lié à ladite seconde partie d'un conducteur associé de ladite pluralité de conducteurs allongés de câblage (152).

2. Dispositif à semi-conducteurs du type à film de support selon la revendication 1, dans lequel un élément passif est connecté à un (dit) conducteur allongé de câblage (152).

3. Dispositif à semi-conducteurs du type à film de support selon la revendication 1 ou la revendication 2, dans lequel la puce à semi-conducteurs (12) est enfermée dans le trou de dispositif (112) par un matériau de scellement.

4. Procédé de fabrication d'un dispositif à semi-conducteurs du type à film de support comprenant les étapes de :
préparation d'une puce à semi-conducteurs (12) ayant une pluralité de plots de connexions (12A) formés à la périphérie d'une surface principale de celle-ci ;
préparation d'une première section de bande de support (11) en un matériau isolant, ladite première bande de support comportant un trou de dispositif (112) plus large que ladite surface principale de ladite puce à semi-conducteurs (12) pour y placer ladite puce à semi-conducteurs (12) ;
formation d'une pluralité de fils métalliques (14) sur une surface de ladite première section de bande de support (11), lesdits fils métalliques pénétrant dans ledit trou de dispositif (112) ;
préparation d'une seconde section de bande de support (15) en un matériau isolant ayant des première et seconde surfaces principales dont chacune a une aire de surface inférieure à celle de ladite surface principale de ladite puce à semi-conducteurs (12) ;
fixation de la première surface principale à une partie centrale de la surface principale de la puce ;
préparation d'une pluralité de conducteurs allongés de câblage (152) dont chacun comporte une première partie formée sur ladite seconde surface principale de ladite deuxième section de bande de support (15) et une seconde partie s'étendant au-delà de la périphérie extérieure de ladite seconde section de bande de support (15) ; et
mise en contact direct et ainsi liaison directe de chacun desdits plots de connexions (12A) de ladite puce à semi-conducteurs (12) avec ladite seconde partie d'un conducteur associé de ladite pluralité de conducteurs allongés de câblage (152), et de ladite seconde partie de chacun de la pluralité de conducteurs allongés de câblage avec un fil associé de ladite pluralité de fils métalliques (14) par liaison de couplage par thermocompression.

5. Procédé selon la revendication 4, dans lequel la seconde section de bande de support (15) est alignée sous la première section de bande de support (11) de sorte que chaque conducteur allongé de câblage (152) soit aligné avec un fil métallique (14) et un plot de connexion (12A) associés, et les fils métalliques (14) sont liés aux conducteurs allongés de câblage (152) avant que les conducteurs allongés de câblage (152) ne soient liés aux plots de connexion de la puce à semi-conducteurs (12).

6. Procédé selon la revendication 4, dans lequel les conducteurs allongés de câblage (152) sont liés aux plots de connexion (12A) de la puce à semi-conducteurs (12) avant que la seconde section de bande (15) ne soit alignée avec la première section de bande de support (11) de sorte que les conducteurs allongés de câblage (152) soient alignés avec les fils métalliques (14), et les conducteurs allongés de câblage (152) sont ensuite liés aux fils métalliques (14).

7. Procédé selon la revendication 5, comportant la fourniture de la première section de bande de support (11) et de la seconde section de bande de support (15) comme parties de bandes de support respectives comprenant une pluralité desdites sections successives, dans lequel lesdites première et seconde sections sont alignées en engageant des perforations d'entraînement correspondantes (111, 151) dans lesdites première et seconde bandes de support, ladite seconde partie de chaque conducteur allongé de câblage (152) étant sectionnée à partir de la bande de support respective avant d'être liée audit fil métallique (14) associé.
